# EUROPEAN PATENT APPLICATION

(11) **EP 4 822 715 A1**
(43) Date of publication of application: **14.10.2026**
(21) Application number: 26170848.1
(22) Date of filing: 07.04.2026
(51) Int. Cl.: H01B 1/02, B22F 1/18, H01B 1/22, H01R 13/03

(54) **CONDUCTIVE PARTICLES, CONDUCTIVE MATERIALS USED THE SAME**

(30) Priority: 07.04.2025 KR 20250044542
(71) Applicant: Duksan Neolux Co., Ltd, Cheonan-si, Chungcheongnam-do (KR)
(72) Inventor: Kim, Kyung Soo, Cheonan-si, Chungcheongnam-do (KR); Bae, Chang Wan, Cheonan-si, Chungcheongnam-do (KR)
(74) Representative: BCKIP Part mbB

(57) **Abstract**

The present disclosure relates to conductive particles used in COG and COP technologies of display devices, and the gold (Au) content is optimized to an appropriate weight range by weight to lower contact resistance, reduce manufacturing costs, and improve stability against heat and moisture. The conductive particles form a nickel (Ni) conductive layer and a gold (Au) outer layer on the core particle, thereby improving electrical performance and durability. In addition, the present disclosure provides structural stability that can minimize the risk of short circuits and maintain reliability even in fine-pitch environments. The present disclosure is suitable for connection technology of high-precision display devices, such as smartphones and tablet PCs, and can be utilized in next-generation ultra-thin and high-resolution display panels.

## Description

### TECHNICAL FIELD

The present disclosure relates to a conductive particle including a core; a conductive layer, an anisotropic conductive material and a connection structure using the same.

### BACKGROUND

Anisotropic conductive materials (ACMs) are key technical materials used in manufacturing electronic devices to simultaneously provide electrical and mechanical connections, and are widely utilized mainly in substrate bonding processes such as Chip on Glass (COG) and Chip on Plastic (COP). Anisotropic conductive materials are applied to connection structures such as anisotropic conductive films (ACFs) and anisotropic conductive adhesives (ACPs). They form an electrical connection between two electrodes (a z-axis direction) by applying heat and pressure, while maintaining insulating properties in the x- and y-axis directions (a horizontal direction). These properties enable precise and stable electrical connections in high-resolution display panels, OLEDs, TFT-LCDs, semiconductor packaging, *etc.*

Conductive particles, a key component of anisotropic conductive materials, consist of substrate particles and a conductive layer coating the same. Their size, shape, distribution, and physical properties significantly influence the connection reliability and electrical resistance between electrodes. In particular, COG and COP technologies require high reliability and low contact resistance, depending on the physical properties and microstructure of the substrate. Therefore, the design of the conductive particles is crucial.

In particular, existing conductive particles are mainly designed with structures containing gold (Au), and thus provide high electrical conductivity and superior durability. Gold (Au) is particularly resistant to oxidation and can reduce contact resistance, thereby making it a key material for conductive particles. However, when the gold (Au) content is excessively high, it will increase manufacturing costs, whereas when the gold content is low content, it may degrade electrical characteristics and reliability.

Therefore, there is a pressing need for the development of new conductive particles that can maintain an appropriate gold (Au) content while still providing excellent electrical connectivity and stability. The present disclosure proposes a multilayered conductive particle containing gold (Au) to address this issue, thereby overcoming the limitations of existing technologies.

### SUMMARY

Conductive particles used in Chip on Glass (COG) and Chip on Plastic (COP) technologies enable high-speed data transmission and fine-pitch connections in display devices; however, existing technologies suffer from problems such as increased contact resistance, decreased stability against heat and moisture, risk of short circuits in fine-pitch environments, and increased manufacturing costs. In particular, gold (Au) coated on the outer layer of the conductive particles provides excellent electrical conductivity and durability; however, when the gold (Au) content is excessively high, manufacturing costs increase rapidly, whereas when the content is low, electrical performance and reliability deteriorate.

Furthermore, existing conductive particles lack structural stability under thermal cycling and in humid environments, which limits contact resistance and reliability. This problem is particularly severe in fine-pitch environments, where it can lead to short circuits between adjacent bumps. Therefore, the present disclosure aims to solve these issues by optimizing the gold (Au) content to an appropriate range based on the weight of the conductive particle, thereby lowering contact resistance, improving thermal and moisture stability, and providing a conductive particle that maintains reliability even in fine-pitch environments.

The conductive particle of the present disclosure includes a conductive particle, which includes a core; a conductive layer including Ni, P, and B disposed on the core; and a gold conductive layer including Au on the conductive layer.

It is preferable that the Au in the gold conductive layer is included in an amount of 1 wt% to 10 wt% based on 100 wt% of the weight of the conductive particle.

It is more preferable that the Au is included in an amount of 1 wt% to 7 wt% based on 100 wt% of the weight of the conductive particle.

It is even more preferable that the Au is included in an amount of 3 wt% to 7 wt% based on 100 wt% of the weight of the conductive particle.

It is preferable that the conductive layer further includes Pd.

It is preferable that the conductive layer includes a first conductive layer including Ni and P and a second conductive layer including Ni and B constituted on the first conductive layer.

It is preferable that the core includes monomers consisting of a divinylbenzene-based monomer; a styrene-based monomer; an acrylate-based monomer; a silicone-based monomer; and a combination thereof.

It is more preferable that the styrene-based monomer includes monomers selected from the group consisting of styrene; α-methylstyrene; β-methylstyrene; *p*-methylstyrene; ethylstyrene; hydroxystyrene; vinylxylene; monochlorostyrene; dichlorostyrene; dibromostyrene; vinylnaphthalene; and a combination thereof.

It is more preferable that the acrylate-based monomer includes monomers selected from the group consisting of methyl methacrylate (MMA); ethyl methacrylate; propyl methacrylate; butyl methacrylate; benzyl methacrylate; methyl acrylate (MA); ethyl acrylate (EA); propyl acrylate; butyl acrylate; 2-ethylhexyl acrylate; 1,6-hexanediol diacrylate; tetramethylol methane tetraacrylate; ethylene glycol diacrylate; ethylene glycol dimethacylate; polyethylene glycol diacrylate; polyethylene glycol triacrylate; pentaerythritol tetramethacrylate; and a combination thereof.

It is more preferable that the silicone-based monomer includes monomers selected from the group consisting of vinyltrimethoxysilane; methylchlorosilane; mercaptopropyltrimethoxysilane; vinyltriethoxysilane; phenylchlorosilane; aminopropyltriethoxysilane; epoxycyclohexylethyltrimethoxysilane; [3-(methacryloyloxy)propyl]trimethoxysilane; tetramethoxysilane (TMOS); tetraethoxysilane (TEOS); triethoxyvinylsilane; trimethylchlorosilane (TMCS); hexamethyldisilazane (HMDS); octamethylcyclotetrasiloxane (D4); decamethylcyclopentasiloxane (D5); polymethylphenylsiloxane; polydiphenylsiloxane; tris(trimethylsiloxy)silane; and a combination thereof.

In another aspect of the present disclosure, it is preferable to provide an anisotropic conductive material including the conductive particle.

In still another aspect of the present disclosure, it is preferable to provide a connection structure including the anisotropic conductive material.

It is preferable that the connection structure is Chip On Glass (COG) or Chip On Plastic (COP).

### ADVANTAGEOUS EFFECTS

The conductive particle disclosed in the present disclosure optimizes the gold (Au) content and weight of the conductive particle, thereby simultaneously providing high electrical conductivity and stability. Through the same, it is possible to reduce contact resistance and improve durability against heat and moisture, thereby ensuring long-term reliability.

In addition, by controlling the gold (Au) content to an appropriate level, manufacturing costs can be efficiently reduced, and stable electrical connections can be implemented by minimizing the risk of short circuits between adjacent bumps even in a fine-pitch environment.

In particular, the present disclosure meets the needs of high-speed data transmission and fine circuit design when applied to COG and COP technologies, and significantly enhances its potential for use in display and semiconductor packaging.

### DETAILED DESCRIPTION

Hereinafter, exemplary embodiments of the present disclosure are described in detail with reference to accompanying drawings. When reference numerals are assigned to components in the drawings, identical components are denoted by the same numerals as much as possible, even if when illustrated in different drawings.

When describing the present disclosure, if a detailed description of a related known configuration or function is determined to obscure the gist of the present disclosure, such detailed description may be omitted. When the terms "include", "have", or "consist of" are used in this specification, other components may be added unless "only" is used. When a component is expressed in the singular form, it may also encompass cases the plural form unless otherwise explicitly stated.

In describing the components of the present disclosure, terms such as first, second, A, B, (a), (b), *etc.* may be used. Such terms are merely used to distinguish one component from another, and do not limit the essence, order, sequence, or number of the components by such terms.

In describing the positional relationship between components, when it is stated that two or more components are "linked", "coupled", or "connected", it should be understood that the components may be directly "linked" "coupled," or "connected" to each other, but may also be "linked", "coupled", or "connected" with one or more other components interposed therebetween. In particular, the other component may be included in at least one of the two or more components that are "linked", "coupled", or "connected" to each other.

In addition, when a layer, film, region, plate, *etc.* is described as being "on" or "over" another component, it should be understood that this includes not only cases where it is disposed "directly on" the other component, but also cases where another component is interposed therebetween. In contrast, when a component is described as being "directly on" another component, it should be understood that there is no other component interposed therebetween.

In describing the temporal flow relationship among components, operating steps, or manufacturing processes, when expressions such as "after", "following", "subsequent to", or "before" are used to describe the order or sequence in time or process flow, it can also include cases where it is not continuous, unless "immediately" or "directly" is used.

Meanwhile, when numerical values or corresponding information for components are mentioned, even without separate explicit description, the numerical values or corresponding information may be interpreted as including an error range that may occur due to various factors (*e.g.,* process factors, internal or external impact, noise, *etc*.).

The terms used in this specification and the accompanying claims have the following meanings, unless otherwise stated, without departing from the spirit of the present disclosure.

Hereinafter, implementation examples of the present disclosure will be described in detail. However, these are provided as examples and The Present Disclosure is not limited thereby, and the present disclosure is defined only by the scope of the claims described below.

Each component is described in detail below.

Each component is described in detail below.

### 1. Conductive particle

The conductive particles according to the embodiments of the present disclosure are utilized as an anisotropic conductive material and are applied to Chip On Glass (COG) and Chip On Plastic (COP) substrates to simultaneously provide electrical connection and insulation.

The conductive particles may consist of metals or metal alloys, such as silver, copper, nickel, or gold, and may also include polymer particles coated with metal. The particle sizes range from hundreds of nanometers to tens of micrometers and may have a uniform or nonuniform size distribution. The conductive particles of the present disclosure provide electrical conductivity in the vertical direction and maintain insulation in the horizontal direction, thereby preventing short circuits between fine-pitch electrodes. This makes them suitable for high-resolution displays and miniaturized electronic devices.

In particular, the COG method directly connects the display panel's glass substrate and the driver IC, thereby enabling the production of miniaturized electronic devices, and through a thermocompression process, it is possible to form a stable electrical connection between the upper and lower electrodes. The COP method is also applied in a similar method to plastic substrates, and plays a crucial role in applications such as flexible displays.

As a result, the conductive particles according to the embodiments of the present disclosure enable high-density and high-reliability electrical connections on COG and COP substrates, which is evaluated as an important innovative element in display technology and manufacturing other electronic devices.

The conductive particles according to the embodiments of the present disclosure include a core; a conductive layer including Ni, P, and B disposed on the core; and a gold conductive layer including Au on the conductive layer, and it is preferable that the Au in the gold conductive layer is included in an amount of 1 wt% to 10 wt% based on 100 wt% of the weight of the conductive particle.

### 1-1. Core

The core is an insulating particle with very low electrical conductivity, may be prepared as a resin particle, and is applied to an anisotropic conductive material, and is thus prepared as a material that does not break easily when the conductive particles are electrically connected.

It is preferable that the particle size of the above core is in the range of 1.0 µm to 6.0 µm.

It is preferable that the core includes a monomer consisting of a divinylbenzene-based monomer; a styrene-based monomer; an acrylate-based monomer; a silicone-based monomer; and a combination thereof.

The divinylbenzene-based copolymers are mainly prepared by a copolymerization reaction using a divinyl benzene monomer and a styrene-based monomer, and in this process, divinyl benzene acts as a crosslinking agent to control the physical and chemical properties of the polymer.

As the styrene-based monomer, one or more selected from the group consisting of styrene; α-methylstyrene; β-methylstyrene; *p*-methylstyrene; ethylstyrene; hydroxystyrene; vinylxylene; monochlorostyrene; dichlorostyrene; dibromostyrene; and vinylnaphthalene may be used.

As the acrylate-based monomer, one or more selected from the group consisting of methyl methacrylate (MMA); ethyl methacrylate; propyl methacrylate; butyl methacrylate; benzyl methacrylate; methyl acrylate (MA); ethyl acrylate (EA); propyl acrylate; butyl acrylate; 2-ethylhexyl acrylate; 1,6-hexanediol diacrylate; tetramethylol methane tetraacrylate; ethylene glycol diacrylate; ethylene glycol dimethacylate; polyethylene glycol diacrylate; polyethylene glycol triacrylatee; and pentaerythritol tetramethacrylate may be used.

As the silicone-based monomer, one or more selected from the group consisting of vinyltrimethoxysilane; methylchlorosilane; mercaptopropyltrimethoxysilane; vinyltriethoxysilane; phenylchlorosilane; aminopropyltriethoxysilane; epoxycyclohexylethyltrimethoxysilane; [3-(methacryloyloxy)propyl]trimethoxysilane; tetramethoxysilane (TMOS); tetraethoxysilane (TEOS); triethoxyvinylsilane; trimethylchlorosilane (TMCS); hexamethyldisilazane (HMDS); octamethylcyclotetrasiloxane (D4); decamethylcyclopentasiloxane (D5); polymethylphenylsiloxane; polydiphenylsiloxane; tris(trimethylsiloxy)silane; and a combination thereof may be used.

### 1-2. Conductive layer

It is preferable that the conductive layer of the present disclosure includes Ni; P; and B.

It is preferable that the conductive layer further includes Pd.

Specifically, the conductive layer may consist of three elements of Ni-P-B including Ni, or four elements of Ni-P-B-Pd, but is not limited thereto.

It is preferable that the conductive layer includes a first conductive layer including Ni and P and a second conductive layer including Ni and B constituted on the first conductive layer.

It is preferable that the conductive layer including Ni has a thickness of 80 nm to 400 nm, more preferably 90 nm to 300 nm, and most preferably 100 nm to 250 nm.

When the thickness of a conductive layer is less than the above range, the electrical resistance of the conductive particle increases, whereas when it exceeds the above range, peeling of the conductive layer and an insulating core may occur even if the conductive particle is slightly deformed under the heating/pressure bonding conditions of the anisotropic conductive material, which may lower the reliability of the product.

It is preferable that the conductive layer consists of a conductive layer including Ni; and a gold conductive layer including Au constituted on the conductive layer.

It is preferable that the weight ratio (wt%) of Au in the gold conductive layer is 1 wt% to 10 wt% relative to the total weight of the conductive particle (100 wt%).

It is more preferable that the weight ratio of Au is 1 wt% to 7 wt%.

It is even more preferable that the weight ratio of Au is 3 wt% to 7 wt%

Within the above weight range, a uniform Au coating is formed on a conductive layer; therefore, it is possible to maintain low substrate contact resistance and electrical conductivity, while achieving an optimal balance between the manufacturing cost and performance. This optimal range is suitable for high-speed data transmission and fine-pitch connections required in COG and COP technologies.

When the weight ratio of the Au is below the range, the Au coating layer on the conductive layer is not sufficiently formed; therefore, the electrical connection on the surface of the conductive particle is incomplete, which may increase the contact resistance and lower the reliability, and the durability against heat and moisture may be weakened, thereby making it difficult to secure long-term stability.

Additionally, the conductive layer may include a protrusion.

The shape of the protrusion may be spherical, elongated, or a cluster of multiple particles, but is not limited thereto. The most preferred shape is one that tapers toward the ends.

The size of the protrusions is preferably 50 nm to 500 nm, and preferably 100 nm to 350 nm.

It is preferable to apply an anticorrosion treatment to the outer surface of the conductive layer. This treatment increases the contact angle between the conductive layer surface and moisture, thereby enhancing reliability in high-humidity environments; additionally, it has the effect of minimizing the degradation of the performance of the connecting member due to the dissolution of impurities in water. Therefore, as the anticorrosive agent, those having a hydrophobic property are generally used. Methods for applying an anticorrosive coating to the surface of the conductive layer include dissolving the anticorrosive agent in a solvent and then dipping or spraying it onto the surface of the conductive particle. Furthermore, hydrophilic treatment is also possible to achieve a combination with the properties of the ACF resin.

### 1-3. Insulating particle layer

Insulating particles are particles which are formed in a first region on a conductive layer to prevent short circuits with adjacent electrodes when a conductive particle is used as an anisotropic conductive material, and when protrusions are provided, the insulating particles may also be provided on the protrusions.

As the material for insulating particles, insulating resin particles or inorganic particles may be used. The resin particles include one or more resins selected from the group consisting of styrene or a styrene-based material containing an alkyl group having one or more carbon atoms, and an acrylate-based material comprising an acrylate or methacrylate containing an alkyl group having one or more carbon atoms, or a diacrylate or dimethacrylate at both ends of a glycol having one or more carbon atoms; and the inorganic particles include one or more materials selected from the group consisting of a trimethoxysilane-based material containing an acrylic group, a phenyl group, and a vinyl group.

The particle size may be 90 nm or larger to exhibit an insulating effect, but is preferably 100 nm to 300 nm, and more preferably 100 nm to 250 nm, to secure connection resistance and insulation resistance.

Additionally, to improve insulation and electrical conductivity, insulating particles of different particle sizes may be mixed and used, and organic/inorganic particles may also be mixed and used.

As a method for attaching insulating particles to the surface of a conductive particle, a method (wet method) is used, in which a solvent, a conductive particle, and an insulating particle are mixed together and attached, and the insulating particle, which is a polymer having, on its surface, a first substituent that has a bonding force with the metal of the conductive layer of a conductive particle, and is attached to the conductive layer or the protrusion of the insulating particle by means of the first substituent.

The first substituent may be any heteroatom or substituent that forms a covalent bond, polar bond, or other bonding interaction with a metal or has a high affinity for the metal and can be attached and fixed to the metal surface. Specifically, the first substituent may be selected from the group consisting of a hetero group, an ether group, a carbonic acid group, and a hydroxyl group, and at least one hetero group selected from the group consisting of sulfur, phosphorus, nitrogen, and oxygen may preferably be used.

In particular, it is preferable that the insulating particles be attached to 5% to 40% of the total surface area of the conductive layer (including protrusions, if any). When the proportion is less than 5%, the insulating particle ratio is low, making it difficult to exhibit an insulating effect, whereas when it exceeds 40%, there is a problem in the connection resistance increases as the number of insulating particles increases. Therefore, even when insulating particles are attached, a portion of the conductive layer surface of a conductive particle remains exposed.

It is preferable that the average diameter of the above-mentioned conductive particles is 1.5 µm to 5.0 µm.

The average diameter of the prepared core resin particles is measured using a mode value using a Particle Size Analyzer (BECKMAN MULTISIZER TM3). The number of core particles measured at this time is 75,000.

### 2. Preparation of conductive particles

A method for preparing a conductive particle according to an example of the present disclosure includes a step of providing an insulating core (S1), a step of forming a conductive layer (S2), a step of surface treatment (S3), and a step of drying (S4).

In particular, the step of providing an insulating core (S1) includes a step of synthesizing insulating core particles (S1a) and a step of activating a plating catalyst (S1b).

First, the step of synthesizing insulating core particles (S1a) is a step of preparing an insulating core by polymerizing a copolymer using a monomer such as divinylbenzene, styrene-based, acrylate-based, or a mixed monomer of the foregoing monomers, by a method such as seed polymerization, dispersion polymerization, suspension polymerization, and emulsion polymerization.

As the styrene-based monomer, one or more monomers selected from the group consisting of styrene; α-methylstyrene; β-methylstyrene; *p*-methylstyrene; ethylstyrene; hydroxystyrene; vinylxylene; monochlorostyrene; dichlorostyrene; dibromostyrene; and vinylnaphthalene may be used.

As the acrylate-based monomer, one or more monomers selected from the group consisting of methyl methacrylate (MMA); ethyl methacrylate; propyl methacrylate; butyl methacrylate; benzyl methacrylate; methyl acrylate (MA); ethyl acrylate (EA); propyl acrylate; butyl acrylate; 2-ethylhexyl acrylate; 1,6-hexanediol diacrylate; tetramethylol methane tetraacrylate; ethylene glycol diacrylate; ethylene glycol dimethacylate; polyethylene glycol diacrylate; polyethylene glycol triacrylate; and pentaerythritol tetramethacrylate may be used.

After the core formation, the core particles are finally obtained through filtration, washing, classification, and drying processes.

The core particles generated in the above processes may have various average diameter distributions, and may be separated into core particles having a specific average diameter through the classification process.

It is preferable that the particle size of the core particles is 1.0 µm to 6.0 µm.

Then, in the step of activating a plating catalyst (S1b), the core particles prepared in the previous step S1a are activated with an electroless plating catalyst. In particular, the plating catalyst used in the step of activating a plating catalyst (S1b) may be replaced with attaching a small metal or inorganic particles to insulating particles, as long as this can provide the same effect.

Specifically, in the step of activating a plating catalyst (S1b), core particles are treated with a surfactant and then pretreated using various methods known for sensitizing an electroless plating catalyst, and then the sensitized insulating core particles are placed into a solution containing a precursor of the electroless metal plating catalyst and then subjected to activation treatment.

The core particles activated in this manner are placed in a solution containing a strong acid and stirred at room temperature to perform acceleration treatment, thereby obtaining catalyst-treated insulating core particles for electroless plating.

Then, the step of forming a conductive layer with protrusions (S2) includes an insulating core dispersion step (S2a) and a step of forming a conductive layer (S2b).

The insulating core dispersion step (S2a) involves dispersing the insulating core in an alloy plating solution that will form the conductive layer. The alloy plating solution is prepared by sequentially dissolving a precursor of an alloy element, a complexing agent, a stabilizer, and a surfactant.

The catalyst-treated insulating core particles obtained in the step (S1b) are added to the prepared plating solution, and dispersion treatment is performed using an ultrasonic homogenizer.

It is preferable to adjust the pH of the dispersion treatment solution to pH 5.5 to 6.5 using ammonia water, *etc.,* because this improves the adhesion and dispersibility of the insulating core and the conductive layer in the initial Ni reduction reaction in the step of forming a conductive layer (S2b) described later. When the pH is below 5.5, for example, pH 4 or lower, the adhesion and dispersibility are good, but the reactivity is too low; therefore, there is a possibility that some particles may not be plated, whereas when the pH is high exceeding 6.5, the conductive layer surface may be formed sparsely due to abnormal precipitation of Ni, resulting in poor adhesion and dispersibility.

Subsequently, a treatment (S2b), in which a conductive layer is formed on the insulating core immersed in the dispersion-treated plating solution, is performed. The number of layers, materials, and the method of forming the conductive layer or the method of forming protrusions are not limited. It is preferable that the thickness of the conductive layer is formed to be 80 nm to 400 nm, and the protrusions may be formed integrally or separately. For example, the protrusions may be grown integrally with the conductive layer, or the conductive layer may be formed after nano-sized particles are attached to the insulating core, or the first conductive layer may be formed on the insulating core, nano-sized particles may be attached thereto, and a second conductive layer made of the same or different material as the first conductive layer may be formed to form the protrusions.

As the formation of protrusions integrally with the conductive layer, for example, in the core dispersion step (S2a), one or more precursors selected from P and B are added to the nickel-based alloy plating solution, and in the step of forming a conductive layer with protrusions (S2b), alloy elements including one or more precursors selected from Cu, Au, Ag, W, Mo, Pd, Co, and Pt are dividedly added to the dispersion-treated plating solution to form a conductive layer with protrusions through a concentration gradient.

In particular, the alloy elements that are dividedly added may be added in 2 to 5 divided portions at intervals of 10 to 30 minutes, or in 2 to 4 divided portions at intervals of 15 to 25 minutes. In particular, the addition amount may be added in divided portions with increased content, or may be added continuously as needed; however, it is preferable to increase the amount added at certain time intervals according to the addition rate because this can increase the concentration in the direction of the protrusions.

Before and after the above-described divided addition, it is preferable to maintain the pH of the plating solution within a controlled range according to the type of the alloy elements added to form a conductive layer with protrusions. For example, in a case where a precursor of P is added, it is preferable to maintain the pH to be within a range of 5.5 to 6.0, whereas in a case where a precursor of B is added, it is desirable to maintain the pH within a range of 8.5 to 9.0. In particular, when the pH of the plating solution is low, the reactivity is low, thereby causing a problem in forming protrusions, whereas when the pH is too high, excessive abnormal precipitation occurs, thereby breaking the balance of the plating solution and resulting in defective plating.

In addition, it is more preferable to provide a temperature rise condition so that the desired protrusion can be formed without excessive abnormal precipitation among the protrusion-forming mechanisms.

The surface treatment step (S3) is a step of introducing a metal oxide layer to the surface of a conductive particle.

It is preferable that the surface treatment step (S3) is performed using a wet method.

The surface treatment step (S3) may employ a method of dissolving the surface treatment material in a solvent and then depositing; or spraying it on the surface of conductive particles.

The wet method allows for uniform particle attachment, but requires subsequent drying of the conductive particles.

The surface treatment increases the contact angle between the conductive layer surface and moisture, thereby enhancing reliability in high-humidity environments; additionally, it has the effect of reducing the degradation of the performance of the connecting member due to impurities dissolving in water. Therefore, it is generally preferable to use a surface treatment material with a hydrophobic property.

As a material forming a surface treatment layer, a compound may be used that has hydrophobic properties and includes at least one substituent selected from the group consisting of a thiol group, a phosphoric acid group, and a phosphoric acid ester group, which are substituents capable of binding to a metal, and includes a hydrophobic hydrocarbon chain having 3 or more carbon atoms.

The hydrophobic hydrocarbon having 3 or more carbon atoms may be a material having a fatty acid series, an alkyl group, or a phenol group, and more specifically, the material may be one which includes a C₆ to C₆₀ alkyl group, a C₆ to C₆₀ cycloalkyl group, a C₆ to C₆₀ aryl group, a C₇ to C₆₀ arylalkyl group, a C₃ to C₆₀ alkyl ether group, or two or more of the above materials in a chain.

The drying step (S4) is a step for drying a conductive particle prepared by a wet method, in which the drying process is performed at a temperature between 100°C and 200°C, although the drying temperature may vary depending on the type of solvent.

The anisotropic conductive material consisting of a mixture of the conductive particles and insulating particles of the present disclosure is prepared by mixing the conductive particles prepared in steps (S1) to (S4) and the insulating particles that have been washed, classified, and dried in the insulating core providing step (S1).

The mixing process is preferably performed by a physical method. Specifically, it is preferably performed using equipment such as a roll mill or a stirrer.

It is preferable that the average diameter of the conductive particles is larger than that of the above-mentioned insulating particles.

It is preferable that the average diameter of the conductive particles is 1.5 µm to 5.0 µm.

The average diameter of the prepared core resin particles is measured using a mode value measured using a Particle Size Analyzer (BECKMAN MULTISIZER TM3). In particular, it is preferable that the number of core particles measured at this time is 75,000.

### 4. Anisotropic conductive material

The conductive particle of the present disclosure may consist of an anisotropic conductive material.

The present disclosure relates to an anisotropic conductive material that may be prepared by dispersing conductive particles in a resin binder. Examples of anisotropic conductive materials include anisotropic conductive materials, anisotropic conductive films (ACFs), and anisotropic conductive sheets. Conductive particles may be uniformly dispersed in a resin binder and used as anisotropic conductive materials, or may be thinly spread on a release paper surface to form an anisotropic film.

The anisotropic conductive film is preferably 2 to 10 times the size of the conductive particles used. The anisotropic conductive film may consist of only a layer in which conductive particles exist, or may be divided into a layer in which conductive particles exist (a conductive layer) and a layer in which conductive particles do not exist (an insulating layer). The insulating layer may exist above or below a conductive layer, or may exist only on the upper or lower portions. The presence of the insulating layer may vary depending on the application of the ACF used, or may be used to prevent a conductive layer from being broken during use when the thickness is too thin.

In particular, the resin binder is not particularly limited. For example, vinyl-based resins such as styrene-based, acryl-based, and vinyl acetate-based resins; thermoplastic resins such as polyolefin-based and polyamide-based resins; and curable resins such as urethane-based and epoxy-based resins may be used. The resins may be used singly or in combination of two or more types. In particular, it is preferable that the resin binder contain a monomer of the same series as the above-mentioned insulating core, as this can exhibit similar behavior in a changing temperature environment.

For the purpose of polymerization or curing of the binder resin, a radical initiator such as benzoyl peroxide (BPO), a photoinitiator such as trimethylbenzoyl phenylphosphinate (TPO), or an epoxy-based latent curing agent such as HX3941HP may be used alone or in combination.

Additionally, other materials may be added to the resin binder as long as they do not hinder the achievement of the purpose of the present disclosure. Examples include colorants, softeners, heat stabilizers, light stabilizers, antioxidants, inorganic particles, *etc.*

### 5. Connection structure

When a conductive particle is used as described above in the present disclosure, the purpose, structure, and material of a connection structure are not particularly limited. That is, a connection structure is a method of connecting circuit boards using a conductive particle of the present disclosure or an anisotropic conductive material of the present disclosure.

The technology of constituting conductive particles into anisotropic conductive materials and applying them to a connection structure is a key method for simultaneously achieving electrical connection and mechanical fixation in display panels. This connection structure may be implemented, for example, using chip-on-glass (COG) and chip-on-plastic (COP) methods, which attach driver ICs to glass and plastic substrates, respectively, to thereby enable signal transmission between electrodes. Anisotropic conductive materials consist of conductive particles dispersed in a curable resin, and they provide electrical conductivity in the compression direction while maintaining insulation in the vertical direction. These properties enable stable connections even between microscopic electrodes, thereby enhancing the reliability of the connection structure.

The conductive particles enhance electrical reliability and durability through surface treatment, and are deformed by pressure and heat within the connection structure, thereby forming an electrical connection between the upper and lower electrodes. Simultaneously, the resin is cured, thereby providing mechanical stability and enhancing the structural integrity of the connection structure. These conductive particles are compatible with a variety of substrate materials and are designed to ensure high reliability in COG and COP connection structures.

The COG connection structure directly attaches the driver IC to the glass substrate and is designed to ensure stable connections even at fine pitches. This is utilized as an essential technology for applications such as high-resolution displays. The COP connection structure is designed such that the driver IC is attached to a flexible substrate (e.g., flexible displays) for applications so as to maintain reliability even under repeated bending conditions.

The appropriate configuration of conductive particles has a significant impact on the performance of the connection structure. Properly designed conductive particles can reduce the risk of short circuits and ensure stable connections, while array technology allows for maximum efficiency with a minimum number of conductive particles. Connection structures implemented using COG and COP methods offer high precision and reliability, thereby playing a crucial role in next-generation display technologies.

Hereinafter, the Synthesis Examples and Examples according to the present disclosure are described in detail, but the Synthesis examples and Examples of the present disclosure are not limited thereto.

### <Examples>

### I. Preparation of conductive particles

### (Preparation Example 1) Divinylbenzene-based copolymer

To a 3 L glass beaker, 750 g of monomer tetramethylol methane tetraacrylate (TMMT) and 750 g of divinylbenzene (DVB) were added, and then 5 g of initiator BPO was added. The mixture was treated in a 40 kHz ultrasonic bath for 10 minutes to prepare a first solution.

To a 5 L PP beaker, 4,000 g of deionized water, 500 g of dispersion stabilizer polyvinylpyrrolidone (PVP)-30K, and 200 g of surfactant Solusol (dioctyl sulfosuccinate sodium salt) were added and dissolved to prepare a second solution.

The first solution and the second solution were added into a 50 L reactor, and 40,000 g of deionized water was added thereto, and the mixture was treated with an ultrasonic homogenizer (20 kHz, 600 W) for 90 minutes, and the temperature was raised to 35°C while rotating the solution at 120 rpm, and maintained thereat for 3 hours. The temperature was then raised again to 85°C, and after the solution reached 85°C, it was maintained for 16 hours to perform a polymerization process.

The polymerized fine particles were filtered, washed, classified, and dried to obtain core resin particles. The average diameter of the prepared core resin particles was measured using a mode value using a particle size analyzer (BECKMAN MULTISIZER M4). The number of core particles measured at this time was 75,000. The average diameter was 2.8 µm.

### (Preparation Example 2) Divinylbenzene-based copolymer

Core particles were prepared in the same manner as Preparation Example 1, except that 750 g of monomer styrene and 10 g of initiator benzoyl peroxide (BPO) were added to a 3 L glass beaker. The average diameter of the prepared cores was measured using a mode value using a particle size analyzer (BECKMAN MULTISIZER M4). The number of core particles measured at this time was 75,000. The average diameter was 2.8 µm.

### (Preparation Example 3) silicone-based copolymer

A dilute base aqueous solution (a) was prepared by adding 1.2 g of 3% ammonia water to 200 g of deionized water, and a monomer mixture solution (b) was prepared by mixing 10 g of 3-methacryloxypropyltrimethoxysilane (MPTMS). The base aqueous solution (a) was stirred at low speed, the monomer mixture solution (b) was added thereto, and the reaction was allowed to proceed overnight at room temperature to synthesize a core intermediate.

Then, 1.0 g of organic monomer hexandiol diacrylate (HDDA) was added, the temperature was raised to 75°C, and an aqueous solution of 0.2 g of KPS dissolved in 5 g of deionized water was added, followed by reaction for 10 hours.

The reaction solution was allowed to settle naturally, the supernatant was removed, 95% ethanol was added, and small particles were removed by centrifugation more than 10 times.

The average diameter of the prepared cores was measured using a mode value using a particle size analyzer (BECKMAN MULTISIZER M4). The number of core particles measured at this time was 75,000. The average diameter was 2.8 µm.

### II. Preparation of conductive particles containing conductive layer

### (Preparation Example 4)

### ① Catalytic treatment process

30 g of the cores of Preparation Example 1 prepared in the above process were placed in a solution of 800 g of deionized water, 1 g of surfactant Triton X100, and treated in an ultrasonic bath for one hour to perform a washing and degreasing process to remove excess unreacted monomers and oil components present in the cores. The final step of the washing and degreasing processes was a three-time washing process using 45°C deionized water. The cores on which the above etching process was completed was treated with a Pd catalyst. The cores that had completed the degreasing and washing processes were placed in a solution containing 150 g of stannous chloride and 300 g of 35-37% hydrochloric acid dissolved in 600 g of deionized water, and sensitized by immersion and stirring at 30°C for 30 minutes, and then washed three times.

The sensitized insulating cores were placed in 1 g of palladium chloride, 200 g of a 35-37% hydrochloric acid solution, and 600 g of deionized water, and activated at 40°C for one hour. After the activation process, the water rinsing process was performed three times.

The activated insulating cores were placed in a solution of 100 g of a 35-37% aqueous hydrochloric acid solution and 600 g of deionized water, and stirred at room temperature for 10 minutes to perform acceleration treatment. After the acceleration treatment, the cores were washed three times to obtain catalyst-treated insulating cores for electroless plating.

### ② Process for first conductive layer containing Ni and P

In a 5 L reactor, 300 g of nickel sulfate as a Ni salt, 5 g of sodium acetate as a complexing agent, 2 g of lactic acid, 0.001 g of Pb-acetate as a stabilizer, 0.001 g of sodium thiosulfate, and 1 g of PEG-1200 as a surfactant were sequentially dissolved in 3,500 g of deionized water to prepare Solution (a) for plating. The catalyst-treated insulating cores were added to the prepared solution (a) and dispersed for 10 minutes using an ultrasonic homogenizer. After the dispersion, the pH of the solution was adjusted to 5.7 using ammonia water - Solution (b).

In a 1 L beaker, 380 g of sodium hypophosphite as a reducing agent, and 0.0001 g of sodium thiosulfate as a stabilizer were dissolved in 500 g of deionized water to prepare Solution (c).

While maintaining the temperature of the 5L reactor (Solution (b)) at 65°C, Solution (c) was added at a rate of 10 g per minute using a quantitative pump, and the reactor was heated for 30 minutes to reach 35°C and was maintained thereat.

After completing the addition of Solution (c), the reactor was maintained for 30 minutes to obtain Ni-plated conductive particles.

### ③ Process for second conductive layer containing Ni and B

In a 1 L beaker, 33 g of dimethylamineborane (DMAB) as a reducing agent and 0.002 g of sodium thiosulfate as a stabilizer were dissolved in 500 g of deionized water (DI water) to prepare Solution (a).

In a 1 L beaker, 155 g of nickel sulfate, 0.6 g of PdCl₂, and 10 g of a 35-37% hydrochloric acid solution were dissolved in 500 g of deionized water (DI water) to prepare Solution (b).

The temperature of Solution (c), in which the first conductive layer containing Ni and P was completed, was cooled to reach 35°C and maintained.

The pH of Solution (c) in the 5 L reactor was adjusted to 8.0 by additionally adding ammonia water until the solution temperature reached 35°C.

Solution (a) and Solution (b) were added into the 5 L reactor at a rate of 20 g per minute using a quantitative pump.

After completing the addition of Solution (a) and Solution (b), the reactor was maintained for 30 minutes to reach 35°C to obtain Ni-plated conductive particles.

### (Preparation Example 5)

Conductive particles were prepared in the same manner as in Preparation Example 4, except that the cores of Preparation Example 2 prepared in the above process I.

### (Preparation Example 6)

Conductive particles were prepared in the same manner as in Preparation Example 4, except that the cores of Preparation Example 3 prepared in the above process I.

### III. Preparation of conductive particles containing gold conductive layer containing Au

### (Example 1)

To the conductive particles of Preparation Example 4 prepared in the above process II, 2000 g of deionized water (DI water), 130 g of polyethylene glycol 600 (PEG#600), 42 g of potassium hydroxide (KOH), 74 g of citric acid, and 2 g of potassium gold cyanide were added and the mixture was stirred at 65°C for 1 hour to prepare the conductive particles of Example 1 above.

### (Example 2)

To the conductive particles of Preparation Example 5 prepared in the above process II, 2000 g of deionized water (DI water), 130 g of polyethylene glycol 600 (PEG#600), 42 g of potassium hydroxide (KOH), 74 g of citric acid, and 4 g of potassium gold cyanide were added and the mixture was stirred at 65°C for 1 hour to prepare the conductive particles of Example 2 above.

### (Example 3)

To the conductive particles of Preparation Example 6 prepared in the above process II, 2000 g of deionized water (DI water), 130 g of polyethylene glycol 600 (PEG#600), 42 g of potassium hydroxide (KOH), 74 g of citric acid, and 6 g of potassium gold cyanide were added and the mixture was stirred at 65°C for 1 hour to prepare the conductive particles of Example 3 above.

### (Example 4)

Conductive particles of Preparation Example 4 were prepared in the same manner as in Preparation Example 1 above, except that 8 g of potassium gold cyanide was added in the process of Preparation Example 1 above.

### (Example 5)

Conductive particles of Preparation Example 5 were prepared in the same manner as in Preparation Example 2 above, except that 10 g of potassium gold cyanide was added in the process of Preparation Example 2 above.

### (Example 6)

Conductive particles of Preparation Example 6 were prepared in the same manner as in Preparation Example 3 above, except that 12 g of potassium gold cyanide was added in the process of Preparation Example 3 above.

### (Example 7)

Conductive particles of Preparation Example 7 were prepared in the same manner as in Preparation Example 1 above, except that 14 g of potassium gold cyanide was added in the process of Preparation Example 1 above.

### (Example 8)

Conductive particles of Preparation Example 8 were prepared in the same manner as in Preparation Example 2 above, except that 16 g of potassium gold cyanide was added in the process of Preparation Example 2 above.

### (Example 9)

Conductive particles of Preparation Example 9 were prepared in the same manner as in Preparation Example 1 above, except that 18 g of potassium gold cyanide was added in the process of Preparation Example 1 above.

### (Example 10)

Conductive particles of Preparation Example 10 were prepared in the same manner as in Preparation Example 3 above, except that 20 g of potassium gold cyanide was added in the process of Preparation Example 3 above.

### (Comparative Example 1)

The conductive particles prepared in Preparation Example 4 above were used as Comparative Example 1.

### (Comparative Example 2)

The conductive particles of Comparative Example 2 were prepared in the same manner as in Example 3 above, except that 25 g of potassium gold cyanide was added in the process of Example 3.

The gold content of the gold conductive layer relative to the total mass of the conductive particles of Examples 1 to 10 and Comparative Examples 1 and 2 was measured using an ICP-OES device.

### VI. Preparation of anisotropic conductive films

2 g of naphthalene-based epoxy resin HP4032D (DIC), 20g of phenoxy resin YP-50 (TOTO KASEI), 25 g of acrylic epoxy resin VR-60 (Showa Denko), 22 g of a heat curing agent HXA-3922HP (Asahi Chemical), and 5 g of an epoxy silane coupling agent A-187 (Momentive) were well stirred, and then a mixture having a solid content of 50% was prepared using toluene as a solvent. The conductive particles prepared in Examples 1 to 10 and Comparative Examples 1 and 2 were added in an amount of 10% by weight of the mixture, and then mixed for 5 minutes using an anisotropic conductive mixer at a rotation speed of 150 rpm and a revolution speed of 400 rpm to prepare an anisotropic conductive paste. Using the above anisotropic conductive paste, a 20 µm-thick film was formed on a release film, and then dried in the air using a hot air dryer at 75°C/5 minutes to form a final 12 µm-thick anisotropic conductive film.

### V. Preparation of connection structure

### 1) Electrodes for resistance measurement

For the resistance measurement, a glass substrate with a transparent electrode formed by depositing indium tin oxide (ITO) on a glass substrate and an FPCB with an electrode width of 20 µm and an electrode spacing of 50 µm were prepared.

### 2) Bonding

The above anisotropic conductive film was cut to a width of 3 mm, and it was pressed at 0.2 MPa, 120°C, and 10 seconds on a glass substrate with ITO using a bonding jig of 1 mm in width and 30 mm in length, and then FPCB was placed on it and bonded at 45 MPa, 200°C, and 20 seconds to prepare a connection structure.

### VI. Evaluation of performance

### 1) Measurement of initial connection resistance

Resistance was measured using the electrodes of the FPCB of the above connection structure. Resistance was measured using an ADCMT 6871E Digital Multimeter 2probe.

### 2) Measurement of stability (resistance increase rate)

The reliability resistance was measured after leaving it for 250 hours under 85°C/85% humidity conditions, and the stability of the conductive particle according to the resistance increase rate was confirmed as shown in [Equation 1] below. [Equation 1] $\begin{matrix}Resistance Increase Rate \left(%\right) = \\ \left(Resistance After 250 Hours-Initial Connection Resistance\right) / Initial Connection \\ Resistance \times 100 \\ Stability : Stability Resistance / Initial Connection Resistance\end{matrix}$

To measure the resistance, the above-mentioned connected structure, after being left for 250 hours, was placed in a dry oven at 100°C/24 hours to remove any residual moisture, and the resistance was measured using an ADCMT 6871E Digital Multimeter 2probe, which is summarized in Table 1.

**[Table 1]**

| | **Au Content (wt%) (based on 100 wt% of conductive particles)** | **Initial Connection Resistance (Ω)** | **Stability (Resistance Increase Rate after 250 hr under 85/85 (%))** |
|---|---|---|---|
| Comparative Example 1 | 0 | 1.21 | 1,578 |
| Comparative Example 2 | 12.11 | 0.57 | 39 |
| Example 1 | 1.11 | 1.1 | 330 |
| Example 2 | 2.21 | 0.99 | 290 |
| Example 3 | 3.12 | 0.84 | 175 |
| Example 4 | 3.98 | 0.71 | 122 |
| Example 5 | 5.10 | 0.62 | 53 |
| Example 6 | 6.08 | 0.61 | 50 |
| Example 7 | 7.11 | 0.60 | 48 |
| Example 8 | 8.25 | 0.59 | 41 |
| Example 9 | 9.10 | 0.58 | 39 |
| Example 10 | 9.97 | 0.57 | 39 |

Upon comparison of the results of Comparative Examples with Examples in Table 1 above, it can be seen that initial connection resistance is low and stability is improved when the Au content falls within the range specified in the present disclosure. This is believed to be the result of optimizing the gold content on a conductive layer, thereby uniformly applying gold, preventing surface oxidation and enhancing electrical conductivity. This can ultimately result in improved reliability of the conductive particles and the connection structure.

Upon comparison of the results of Comparative Example 1 and Examples, which do not contain gold in the conductive layer, it can be seen that the connection resistance is relatively high and the stability is low. This is believed to be the result of the ineffective oxidation prevention when the gold plating layer is not formed, and the surface of the conductive particle becomes oxidized, thereby resulting in unstable electrical connection.

In contrast, upon comparison of the results of Comparative Example 2 and Examples, which contained excessive amounts of gold in the conductive layer, it can be seen that the connection resistance gradually decreases and becomes similarly measured starting at 5%. Considering that the connection resistance no longer decreases when the gold coating exceeds a certain concentration, it is believed that there is a concentration threshold. Therefore, an excessive gold content leads to a sharp increase in manufacturing costs, which reduces economic feasibility. Therefore, setting the upper and lower limits of the gold content in the present disclosure has important critical significance from both technical and economic perspectives.

The foregoing description is merely illustrative embodiments of the present disclosure, and those skilled in the technical field of the present disclosure will be able to make various modifications without departing from the essential characteristics of the present disclosure.

Accordingly, the embodiments disclosed in this specification are intended to illustrate, rather than limit, the present disclosure, and the spirit and scope of the present disclosure are not limited by these embodiments. The scope of protection of the present disclosure should be interpreted by the claims, and all technologies within the scope equivalent thereto should be construed as being included within the scope of the rights of the present disclosure.

## Claims

1. A conductive particle comprising a core; a conductive layer comprising Ni, P, and B disposed on the core; and a gold conductive layer comprising Au on the conductive layer,
wherein the Au in the gold conductive layer is included in an amount of 1 wt% to 10 wt% based on 100 wt% of the weight of the conductive particle.

2. The conductive particle of claim 1, wherein the conductive layer further comprises Pd.

3. The conductive particle of claim 1, wherein the conductive layer comprises a first conductive layer comprising Ni and P and a second conductive layer comprising Ni and B constituted on the first conductive layer.

4. The conductive particle of claim 1, wherein the core comprises monomers consisting of a divinylbenzene-based monomer; a styrene-based monomer; an acrylate-based monomer; a silicone-based monomer; and a combination thereof.

5. The conductive particle of claim 4, wherein the styrene-based monomer comprises monomers selected from the group consisting of styrene; α-methylstyrene; β-methylstyrene; p-methylstyrene; ethylstyrene; hydroxystyrene; vinylxylene; monochlorostyrene; dichlorostyrene; dibromostyrene; vinylnaphthalene; and a combination thereof.

6. The conductive particle of claim 4, wherein the acrylate-based monomer comprises monomers selected from the group consisting of methyl methacrylate (MMA); ethyl methacrylate; propyl methacrylate; butyl methacrylate; benzyl methacrylate; methyl acrylate (MA); ethyl acrylate (EA); propyl acrylate; butyl acrylate; 2-ethylhexyl acrylate; 1,6-hexanediol diacrylate; tetramethylol methane tetraacrylate; ethylene glycol diacrylate; ethylene glycol dimethacylate; polyethylene glycol diacrylate; polyethylene glycol triacrylate; pentaerythritol tetramethacrylate; and a combination thereof.

7. The conductive particle of claim 4, wherein the silicone-based monomer comprises monomers selected from the group consisting of vinyltrimethoxysilane; methylchlorosilane; mercaptopropyltrimethoxysilane; vinyltriethoxysilane; phenylchlorosilane; aminopropyltriethoxysilane; epoxycyclohexylethyltrimethoxysilane; [3-(methacryloyloxy)propyl]trimethoxysilane; tetramethoxysilane (TMOS); tetraethoxysilane (TEOS); triethoxyvinylsilane; trimethylchlorosilane (TMCS); hexamethyldisilazane (HMDS); octamethylcyclotetrasiloxane (D4); decamethylcyclopentasiloxane (D5); polymethylphenylsiloxane; polydiphenylsiloxane; tris(trimethylsiloxy)silane; and a combination thereof.

8. An anisotropic conductive material comprising the conductive particle of claim 1.

9. A connection structure comprising the anisotropic conductive material of claim 8.

10. The connection structure of claim 9, wherein the connection structure is Chip On Glass (COG) or Chip On Plastic (COP).
